# EUROPEAN PATENT SPECIFICATION

(11) **EP 3 367 434 B1**
(45) Date of publication and mention of the grant of the patent: **16.06.2021**
(21) Application number: 18159014.2
(22) Date of filing: 27.02.2018
(51) Int. Cl.: H01L 23/38

(54) **CHIP PACKAGING SYSTEM**
CHIP-VERPACKUNGSSYSTEM
SYSTÈME D'EMBALLAGE DE PUCE

(30) Priority: 28.02.2017 CN 201710113267
(43) Date of publication of application: 29.08.2018
(73) Proprietor: Huawei Technologies Co., Ltd., Longgang District Shenzhen Guangdong 518129 (CN)
(72) Inventor: FU, HuiLi, Shenzhen, Guangdong 518129 (CN); FU, Xing, Shenzhen, Guangdong 518129 (CN); CAI, Shujie, Shenzhen, Guangdong 518129 (CN); ZHANG, Xiangxiong, Shenzhen, Guangdong 518129 (CN)
(74) Representative: Pfenning, Meinig & Partner mbB

(56) References cited:
- EP-A1- 2 317 550
- DE-A1-102005 008 361
- JP-A- 2002 100 714
- US-A1- 2002 063 327
- US-A1- 2009 250 806
- US-A1- 2015 035 134
- US-A1- 2015 162 307

## Description

### TECHNICAL FIELD

This application relates to the field of electronics, and more specifically, to a chip packaging system.

### BACKGROUND

In a system-level chip package, multiple chips and a passive component are packaged and integrated into a structure of a small size. This dramatically improves functionality. However, a heat dissipation issue of the package becomes more critical than that of a package with a single chip. First, because of different power consumption, different chips may have different temperatures when working. Heat transfers from a chip with a higher temperature to a chip with a lower temperature, causing thermal crosstalk between chips. Because different chips have different working temperature requirements, thermal crosstalk possibly causes that a temperature of a chip with a low allowable working temperature exceeds an allowable value, resulting in damage to the chip. Therefore, a necessary measure needs to be taken to mitigate the problem of crosstalk between chips. Second, as a quantity of chips in a package increases, heat generated in a working process of the chips in the package increases greatly. To control a temperature of a chip to be within an allowable range, how to effectively conduct heat from inside of a package to outside is an unavoidable issue

US2015162307 discloses packages with thermal management features for reduced thermal crosstalk and methods of forming same.

### SUMMARY

This application provides a chip packaging system, which can reduce thermal crosstalk between chips within a package while improving a heat dissipation capability of a particular chip.

According to a first aspect, a chip packaging system according to claim 1 is provided.

Therefore, in an embodiment of this application, the multiple chips are enclosed in independent space, and different chips of the multiple chips are separated by using the thermal insulation material or by air. In addition, a thermoelectric refrigeration chip is disposed on a particular chip of the multiple chips, to improve a heat dissipation capability of the particular chip while overcoming crosstalk between chips. This effectively resolves a problem that heat generation by a chip affects the chip itself.

Optionally, in an implementation of the first aspect, the multiple chips include a first chip and a second chip, one end of the first chip is secured to the substrate, and the other end, opposite to the end secured to the substrate, of the first chip is secured to a first heat dissipating area of the heat dissipating lid, and one end of the second chip is secured to the substrate, and the other end, opposite to the end secured to the substrate, of the second chip is secured to a second heat dissipating area of the heat dissipating lid.

Optionally, in an implementation of the first aspect, the first heat dissipating area and the second heat dissipating area are connected by using a bonding structure, and the first heat dissipating area and the second heat dissipating area are separated by using the thermal insulation material; or
the first heat dissipating area and the second heat dissipating area are connected by using a slotted structure, and the first heat dissipating area and the second heat dissipating area are separated by using a slot; or
the first heat dissipating area and the second heat dissipating area are separated by air.

Therefore, in the chip packaging system according to this embodiment of this application, different areas of the heat dissipating lid are connected by using the bonding structure or the slotted structure, or are separated by air. This enhances overall mechanical strength of the heat dissipating lid and improves structural stability of the chip packaging system.

In an implementation of the first aspect, the heat dissipating ring is of a separated structure and includes multiple sub-rings, and the multiple sub-rings are connected by using a thermal insulation material to form the heat dissipating ring.

Optionally, in an implementation of the first aspect, the heat dissipating ring and the heat dissipating lid are connected by using a thermal insulation material.

Optionally, in an implementation of the first aspect, the heat dissipating ring and the heat dissipating lid are connected directly.

Optionally, in an implementation of the first aspect, the at least one thermoelectric refrigeration chip includes a first thermoelectric refrigeration chip, the first thermoelectric refrigeration chip is disposed above the heat dissipating lid, and a cold end of the first thermoelectric refrigeration chip is attached to an upper surface of the heat dissipating lid.

Optionally, in an implementation of the first aspect, the at least one thermoelectric refrigeration chip includes a second thermoelectric refrigeration chip, the second thermoelectric refrigeration chip is disposed inside the heat dissipating lid, and a cold end of the second thermoelectric refrigeration chip is attached to a lower surface of the heat dissipating lid or a hot end of the second thermoelectric refrigeration chip is attached to the upper surface of the heat dissipating lid.

Optionally, in an implementation of the first aspect, the at least one thermoelectric refrigeration chip includes a third thermoelectric refrigeration chip, the third thermoelectric refrigeration chip is disposed under the heat dissipating lid, and a cold end of the third thermoelectric refrigeration chip is attached to an upper surface of one of the multiple chips.

Optionally, in an implementation of the first aspect, the at least one thermoelectric refrigeration chip includes a fourth thermoelectric refrigeration chip, where
the fourth thermoelectric refrigeration chip is disposed above the heat dissipating lid, and a cold end of the fourth thermoelectric refrigeration chip is attached to an upper surface of the heat dissipating lid; or
the fourth thermoelectric refrigeration chip is disposed inside the heat dissipating lid, and a cold end of the fourth thermoelectric refrigeration chip is attached to a lower surface of the heat dissipating lid or a hot end of the fourth thermoelectric refrigeration chip is attached to an upper surface of the heat dissipating lid; or
the fourth thermoelectric refrigeration chip is disposed under the heat dissipating lid, and a cold end of the fourth thermoelectric refrigeration chip is attached to an upper surface of one of the multiple chips.

Optionally, in an implementation of the first aspect, the system further includes a heat sink, and the heat sink is disposed above the heat dissipating lid and is configured to absorb heat of the heat dissipating lid.

Optionally, in an implementation of the first aspect, the heat sink includes multiple areas, the multiple areas include a first heat sink area and a second heat sink area, the first heat sink area is attached to the first heat dissipating area of the heat dissipating lid, the second heat sink area is attached to the second heat dissipating area of the heat dissipating lid, and the first heat sink area and the second heat sink area are connected by using the thermal insulation material.

Optionally, in an implementation of the first aspect, the heat sink is a whole.

Optionally, in an implementation of the first aspect, a heat conductivity of the thermal insulation material is less than 1.0 W/mK.

Optionally, in an implementation of the first aspect, the at least one thermoelectric refrigeration chip is a power-adjustable thermoelectric refrigeration chip.

Therefore, in the chip packaging system according to this embodiment of this application, heat generated by different chips of the multiple chips is conducted to an outer surface of a packaging structure through different heat conducting channels to reduce heat transfer between the different chips, and a thermoelectric refrigeration chip is used to improve a heat dissipation capability of a particular chip. This improves a heat dissipation capability of the packaging structure of a system-level package with multiple chips, implementing effective control on a temperature of the particular chip.

### BRIEF DESCRIPTION OF DRAWINGS

Embodiments in the figures in which the heat dissipating ring 120 is not of a separated structure are not part of the claimed invention.
FIG. 1 is a schematic planar diagram of a chip packaging system according to an embodiment of this application;
FIG. 2 is a schematic structural diagram of a thermoelectric refrigeration chip according to an embodiment of this application;
FIG. 3 is a chip disposing diagram according to an embodiment of this application;
FIG. 4 is a schematic structural diagram of a heat dissipating lid according to an embodiment of this application;
FIG. 5 is another schematic structural diagram of a heat dissipating lid according to an embodiment of this application;
FIG. 6 is still another schematic structural diagram of a heat dissipating lid according to an embodiment of this application;
FIG. 7 is still another schematic structural diagram of a heat dissipating lid according to an embodiment of this application;
FIG. 8 is still another schematic structural diagram of a heat dissipating lid according to an embodiment of this application;
FIG. 9 is still another schematic structural diagram of a heat dissipating lid according to an embodiment of this application;
FIG. 10 is another chip disposing diagram according to an embodiment of this application;
FIG. 11 is a schematic structural diagram of a heat dissipating ring according to an embodiment of this application;
FIG. 12 is another schematic structural diagram of a heat dissipating ring according to an embodiment of this application;
FIG. 13 is a schematic structural diagram of a manner of connecting a heat dissipating ring to a heat dissipating lid according to an embodiment of this application;
FIG. 14 is another schematic structural diagram of a manner of connecting a heat dissipating ring to a heat dissipating lid according to an embodiment of this application;
FIG. 15 is still another schematic structural diagram of a manner of connecting a heat dissipating ring to a heat dissipating lid according to an embodiment of this application;
FIG. 16 is still another schematic structural diagram of a manner of connecting a heat dissipating ring to a heat dissipating lid according to an embodiment of this application;
FIG. 17 is still another schematic structural diagram of a manner of connecting a heat dissipating ring to a heat dissipating lid according to an embodiment of this application;
FIG. 18 is a schematic structural diagram of an disposing manner of a thermoelectric refrigeration chip according to an embodiment of this application;
FIG. 19 is another schematic structural diagram of an disposing manner of a thermoelectric refrigeration chip according to an embodiment of this application;
FIG. 20 is still another schematic structural diagram of an disposing manner of a thermoelectric refrigeration chip according to an embodiment of this application;
FIG. 21 is still another schematic structural diagram of an disposing manner of a thermoelectric refrigeration chip according to an embodiment of this application;
FIG. 22 is still another schematic structural diagram of an disposing manner of a thermoelectric refrigeration chip according to an embodiment of this application;
FIG. 23 is a schematic structural diagram of a heat sink according to an embodiment of this application; and
FIG. 24 is another schematic structural diagram of a heat sink according to an embodiment of this application.

### DESCRIPTION OF EMBODIMENTS

The following describes technical solutions of this application with reference to accompanying drawings Embodiments described herein in which the heat dissipating ring 120 is not of a separated structure are not part of the claimed invention.

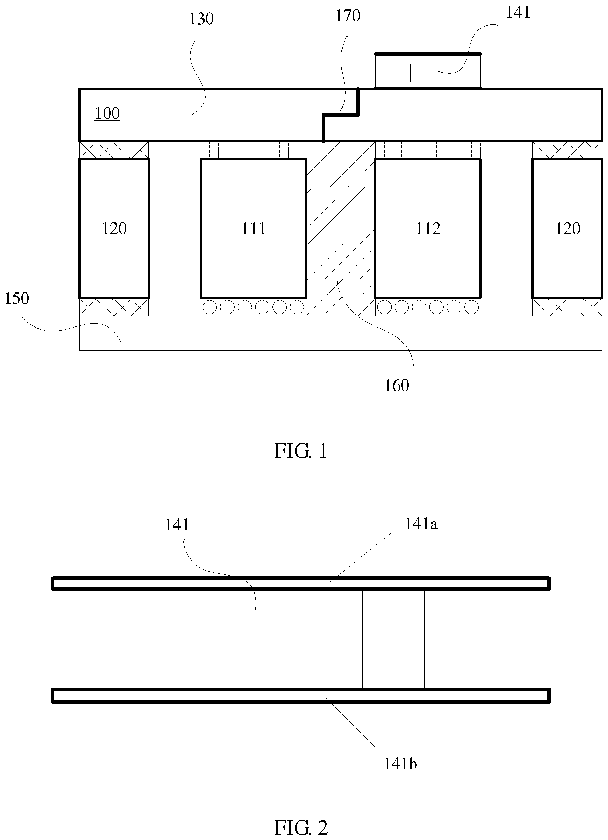

FIG. 1 is a schematic planar diagram of a chip packaging system 100 according to an embodiment of this application. As shown in FIG. 1, the chip packaging system according to this embodiment of this application includes multiple chips, a substrate, a heat dissipating component, and at least one thermoelectric refrigeration chip.

A heat dissipating ring and a heat dissipating lid are provided on the heat dissipating component. One end of the heat dissipating ring is secured to the substrate, and the other end, opposite to the end secured to the substrate, of the heat dissipating ring is secured to the heat dissipating lid to support the heat dissipating lid. The multiple chips are disposed in space enclosed by the substrate, the heat dissipating ring, and the heat dissipating lid, and all of the multiple chips are separated each other by using a thermal insulation material or by air.

Each of the at least one thermoelectric refrigeration chip is disposed above one of the multiple chips. One surface of each thermoelectric refrigeration chip is a hot end and the other surface thereof is a cold end. The cold end of each thermoelectric refrigeration chip is disposed on a side close to the multiple chips and is configured to absorb heat of the chips. The hot end of each thermoelectric refrigeration chip is configured to conduct, by using the hot end, the heat absorbed by the cold end.

Specifically, as shown in FIG. 1, the chip packaging system 100 includes the multiple chips 110, the heat dissipating ring 120, the heat dissipating lid 130, the at least one thermoelectric refrigeration chip 140, and the substrate 150. The heat dissipating ring 120 and the heat dissipating lid 130 form the heat dissipating component.

One end of the heat dissipating ring 120 is secured to the substrate 150 by using thermal insulation adhesive, and the other end, opposite to the end secured to the substrate 150, of the heat dissipating ring 120 is secured to the heat dissipating lid 130 by using the thermal insulation adhesive to support the heat dissipating lid 130. The multiple chips 110 are disposed in space enclosed by the substrate 150, the heat dissipating ring 120, and the heat dissipating lid 130, and all of the multiple chips 110 are separated each other by using a thermal insulation material 160 or by air.

Each of the at least one thermoelectric refrigeration chip 140 is disposed above one of the multiple chips 110. One surface of each thermoelectric refrigeration chip is a hot end and the other surface thereof is a cold end. The cold end of each thermoelectric refrigeration chip is disposed on a side close to the multiple chips and is configured to absorb heat of the chips. The hot end of each thermoelectric refrigeration chip is configured to conduct, by using the hot end, the heat absorbed by the cold end.

For example, as shown in FIG. 1, the multiple chips 110 include a chip 111 and a chip 112, and optionally, may include more chips. One end of the chip 111 is secured to the substrate 150 by using a solder ball, a solder bump, or another material, and the other end, opposite to the end secured to the substrate 150, of the chip 111 is secured to the heat dissipating lid 130 by using thermally conductive adhesive. Likewise, one end of the chip 112 is secured to the substrate 150 by using a solder ball, a solder bump, or another material, and the other end, opposite to the end secured to the substrate 150, of the chip 112 is secured to the heat dissipating lid 130 by using the thermally conductive adhesive. The chip 111 and the chip 112 are separated by using the thermal insulation material 160.

Optionally, the chip 111 and the chip 112 may be separated by air, or the chip 111 and the chip 112 may be separated by using another material of a low heat conductivity.

Optionally, the substrate 150 may be configured to support the multiple chips 110 and the heat dissipating ring 120.

Optionally, the heat dissipating ring 120 and the heat dissipating lid 130 have a relatively high heat conductivity, and heat generated by the chips inside the packaging system may be transferred outside the packaging system by using the heat dissipating ring 120 and the heat dissipating lid 130.

For another example, each of the at least one thermoelectric refrigeration chip 140 includes a cold end and a hot end. Optionally, as shown in FIG. 2, the at least one thermoelectric refrigeration chip 140 includes a thermoelectric refrigeration chip 141, and the thermoelectric refrigeration chip 141 includes a hot end 141a and a cold end 141b.

Optionally, the at least one thermoelectric refrigeration chip 140 may be secured to the heat dissipating lid 130 by using thermally conductive adhesive, or may be secured to the heat dissipating lid 130 by other means.

Optionally, the at least one thermoelectric refrigeration chip 140 may be a power-adjustable thermoelectric refrigeration chip or a power-constant thermoelectric refrigeration chip. Optionally, the at least one thermoelectric refrigeration chip 140 may be connected to an external power supply or may be supplied with a power supply by the chip packaging system 100.

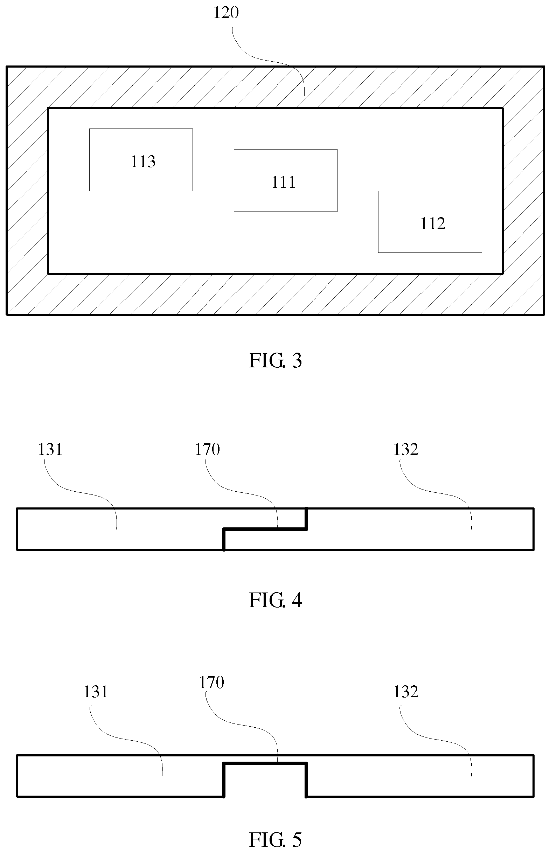

For another example, as shown in FIG. 3, the heat dissipating ring 120 encloses the chip 111, the chip 112, and a chip 113. The chip 111, the chip 112, and the chip 113 are disposed in a distributed manner.

Optionally, in the multiple chips 110, a chip may be a logical chip, a memory, or another component of an electronic packaging device.

Optionally, a heat conductivity of the thermal insulation material 160 is less than 1.0 W/mK.

Therefore, in the chip packaging system according to this embodiment of this application, the multiple chips are enclosed in independent space, and different chips of the multiple chips are separated by using the thermal insulation material or by air. In addition, a thermoelectric refrigeration chip is disposed on a particular chip of the multiple chips, to improve a heat dissipation capability of the particular chip while overcoming crosstalk between chips. This effectively resolves a problem that heat generation by a chip affects the chip itself.

It should be understood that in the chip packaging system, a chip generates heat during working, and the at least one thermoelectric refrigeration chip 140 may always be in an on state or manually turned on and off, or the at least one thermoelectric refrigeration chip 140 may be controlled to be partially or entirely turned on and off by using a controller. This is not limited in this embodiment of this application.

Optionally, in this embodiment of this application, the heat dissipating lid 130 may be divided into multiple heat dissipating areas, and one of the multiple chips 110 is disposed in each heat dissipating area.

Specifically, as shown in FIG. 4, FIG. 5, and FIG. 6, different areas of the heat dissipating lid 130 may be connected by using a bonding structure 170, may be connected by using a slotted structure 170, or may be separated by air.

As shown in FIG. 4, the heat dissipating lid 130 may include a first heat dissipating area 131 and a second heat dissipating area 132. The first heat dissipating area 131 and the second heat dissipating area 132 are connected by using the bonding structure 170, and the first heat dissipating area 131 and the second heat dissipating area 132 are separated by using the thermal insulation material 160. The thermal insulation material 160 is disposed at a position of the bonding structure 170.

As shown in FIG. 5, the heat dissipating lid 130 may include a first heat dissipating area 131 and a second heat dissipating area 132. The first heat dissipating area 131 and the second heat dissipating area 132 are connected by using the slotted structure 170, and the first heat dissipating area 131 and the second heat dissipating area 132 are separated by using a slot.

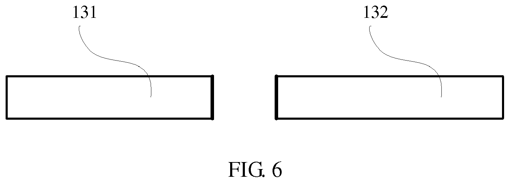

As shown in FIG. 6, the heat dissipating lid 130 may include a first heat dissipating area 131 and a second heat dissipating area 132. The first heat dissipating area 131 and the second heat dissipating area 132 are separated by air.

Optionally, one of the multiple chips 110 is disposed under each area of the heat dissipating lid 130. For example, the multiple chips 110 include the chip 111 and the chip 112. One end of the chip 111 is secured to the substrate 150 by using a solder ball, a solder bump, or another material, and the other end, opposite to the end secured to the substrate 150, of the chip 111 is secured to the first heat dissipating area 131 of the heat dissipating lid 130 by using thermally conductive adhesive. One end of the chip 112 is secured to the substrate 150 by using a solder ball, a solder bump, or another material, and the other end, opposite to the end secured to the substrate 150, of the chip 112 is secured to the second heat dissipating area 132 of the heat dissipating lid 130 by using the thermally conductive adhesive.

Optionally, area division of the heat dissipating lid 130 may be determined according to a quantity of chips. For example, the multiple chips include three chips, and the heat dissipating lid 130 is divided into three areas. One chip is disposed in each area.

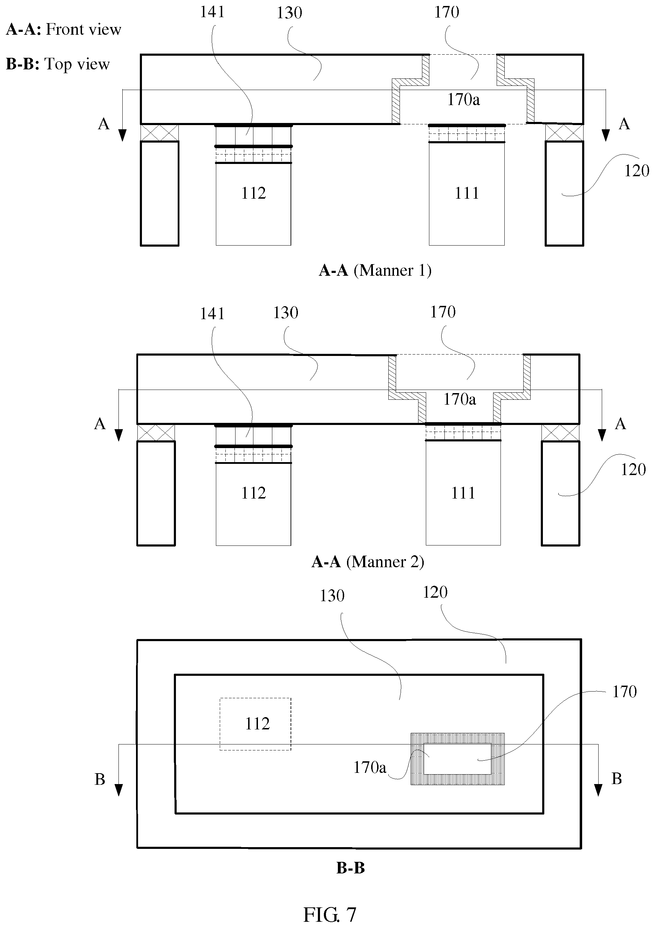

As shown in FIG. 7 (A-A is a front view and B-B is a top view), the heat dissipating lid 130 is connected to the heat dissipating ring 120 by using a thermal insulation material. The heat dissipating lid 130 includes an opening structure 170. The opening structure 170 penetrates through the heat dissipating lid 130. The opening structure 170 includes a filler block 170a. The filler block 170a is made of a same material as the heat dissipating lid 130, and the filler block 170a is connected to the heat dissipating lid 130 by using a thermal insulation material. The opening structure 170 is disposed right above the chip 111. In addition, a size of an opening of the opening structure 170 may be determined according to a size of the chip 111. For example, the opening of the opening structure 170 is slightly larger than the chip in size, and the opening of the opening structure 170 may be in a shape of a rectangle shown in FIG. 7 or in another shape such as an I shape, a circle, or a triangle. As shown in FIG. 7, the chip 112 is disposed under the heat dissipating lid 130. A thermoelectric refrigeration chip 141 is secured to an upper surface of the chip 112 by using thermally conductive adhesive. A cold end of the thermoelectric refrigeration chip 141 is close to the chip 112, and a hot end of the thermoelectric refrigeration chip 141 is attached to a lower surface of the heat dissipating lid 130. An upper surface of the chip 111 is secured to the opening structure 170 by using the thermally conductive adhesive. Optionally, as shown in A-A (Manner 1) and A-A (Manner 2) of FIG. 7, the opening structure 170 and the heat dissipating lid 130 are connected by using a bonding structure. The bonding structure may be in a small-top and large-bottom shape shown in A-A (Manner 1) or in a large-top and small-bottom shape shown in A-A (Manner 2). Optionally, the thermal insulation material in this case may be a material that is the same as the thermal insulation material 160, may be another material of a low heat conductivity, or may be air.

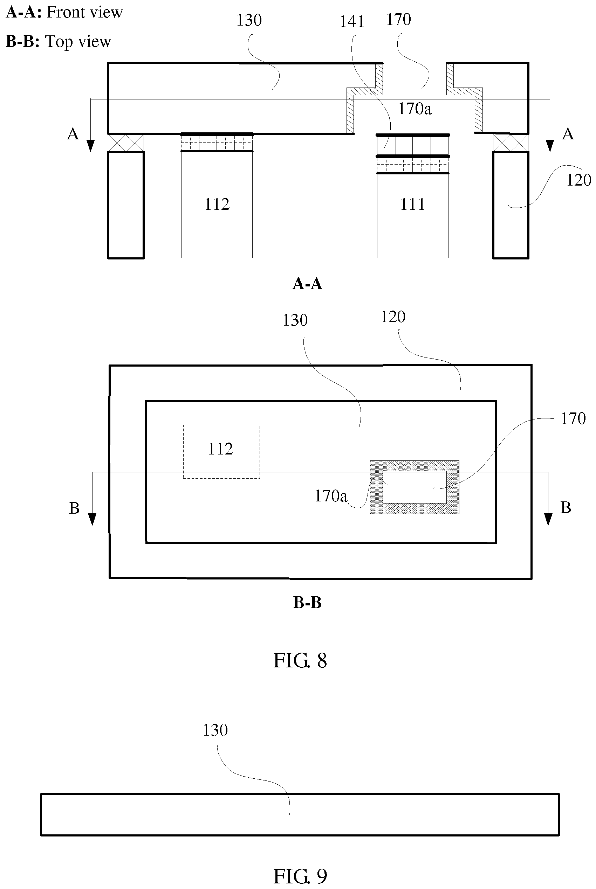

As shown in FIG. 8 (A-A is a front view and B-B is a top view), the heat dissipating lid 130 is connected to the heat dissipating ring 120 by using a thermal insulation material. The heat dissipating lid 130 includes an opening structure 170. The opening structure 170 penetrates the heat dissipating lid 130. The opening structure 170 includes a filler block 170a. The filler block 170a is made of a same material as the heat dissipating lid 130, and the filler block 170a is connected to the heat dissipating lid 130 by using a thermal insulation material. The opening structure 170 is disposed right above the chip 111. In addition, a size of an opening of the opening structure 170 may be determined according to a size of the chip 111. For example, the opening of the opening structure 170 is slightly larger than the chip in size, and the opening of the opening structure 170 may be in a shape of a rectangle shown in FIG. 8 or in another shape such as an I shape, a circle, or a triangle. As shown in FIG. 8, a thermoelectric refrigeration chip 141 is secured to an upper surface of the chip 111 by using thermally conductive adhesive. A cold end of the thermoelectric refrigeration chip 141 is close to the chip 111, and a hot end of the thermoelectric refrigeration chip 141 is attached to the opening structure 170. An upper surface of the chip 112 is secured to the heat dissipating lid 130 by using thermally conductive adhesive.

Optionally, a quantity of opening structures of the heat dissipating lid 130 may be determined according to a quantity of chips. For example, the multiple chips include three chips, and the heat dissipating lid 130 includes three opening structures. One chip is disposed under each opening structure.

Therefore, in the chip packaging system according to this embodiment of this application, different areas of the heat dissipating lid are connected by using a bonding structure or a slotted structure. The different areas of the heat dissipating lid may alternatively be separated by air. The heat dissipating lid may further include multiple opening structures. Each opening structure is connected to the heat dissipating lid by using a bonding structure. This enhances overall mechanical strength of the heat dissipating lid and improves structural stability of the chip packaging system.

Optionally, in this embodiment of this application, the heat dissipating lid 130 may be a whole, and the multiple chips 110 are disposed under the heat dissipating lid 130.

Specifically, as shown in FIG. 9, the heat dissipating lid 130 is a whole. In this case, the heat dissipating lid 130 does not provide an area for each chip by means of division.

Optionally, in this embodiment of this application, all of the multiple chips 110 may be disposed in a distributed manner, or some of the multiple chips 110 may be disposed together and some chips may be disposed separately.

Specifically, as shown in FIG. 3, the heat dissipating ring 120 is of a rectangular closed structure, and encloses the chip 111, the chip 112, and the chip 113. The chip 111, the chip 112, and the chip 113 are disposed in a distributed manner.

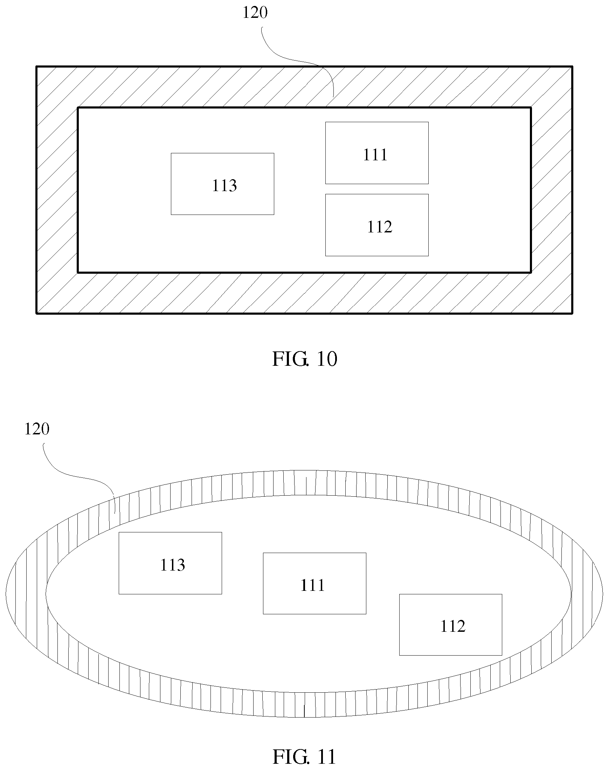

As shown in FIG. 10, the heat dissipating ring 120 is of a rectangular closed structure, and encloses the chip 111, the chip 112, and the chip 113. The chip 111 and the chip 112 are disposed together, and the chip 113 is disposed separately.

Optionally, a specific disposing manner of the multiple chips 110 may be determined according to an actual requirement. For example, the chip 111, the chip 112, and the chip 113 are disposed in a distributed manner, as shown in FIG. 3; the chip 111 and the chip 112 are disposed together and the chip 113 is disposed separately, as shown in FIG. 10; or there may be another disposing manner. This is not limited in this embodiment of this application.

Optionally, in this embodiment of this application, the heat dissipating ring 120 may be in multiple shapes.

Specifically, as shown in FIG. 3, the heat dissipating ring 120 is of a rectangular closed structure, and encloses the chip 111, the chip 112, and the chip 113. As shown in FIG. 11, the heat dissipating ring 120 is of an oval closed structure, and encloses the chip 111, the chip 112, and the chip 113.

Optionally, a specific shape of the heat dissipating ring 120 may be a rectangular structure shown in FIG. 3, an oval structure shown in FIG. 11, or a structure in another shape. This is not limited in this embodiment of this application.

Optionally, in this embodiment of this application, the heat dissipating ring 120 may be of multiple structures.

Specifically, as shown in FIG. 3, the heat dissipating ring 120 is of a rectangular closed structure, and encloses the chip 111, the chip 112, and the chip 113.

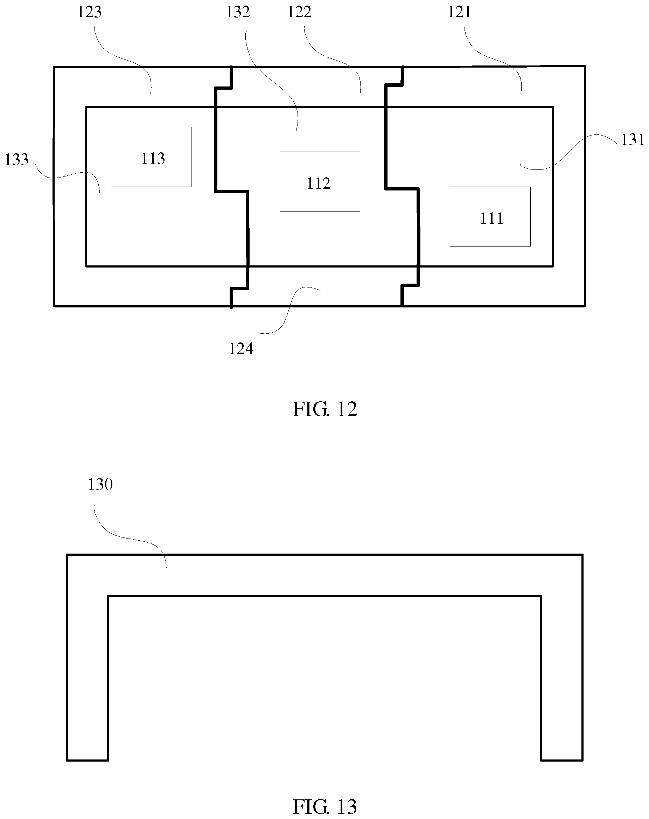

As shown in FIG. 12, the heat dissipating ring 120 is of a rectangular separated structure and includes a first sub-ring 121, second sub-rings 122 and 124, and a third sub-ring 123. The first sub-ring 121 and the second sub-rings 122 and 124 are connected by using a bonding structure, and the first sub-ring 121 is separated from the second sub-rings 122 and 124 by using a thermal insulation material. The third sub-ring 123 and the second sub-rings 122 and 124 are also connected by using a bonding structure, and the third sub-ring 123 is separated from the second sub-rings 122 and 124 by using a thermal insulation material. The heat dissipating ring 120 encloses the chip 111, the chip 112, and the chip 113, and the chip 111, the chip 112, and the chip 123 are disposed in a distributed manner.

Optionally, as shown in FIG. 12, the heat dissipating lid 130 includes a first heat dissipating area 131, a second heat dissipating area 132, and a third heat dissipating area 133. The first heat dissipating area 131 and the second heat dissipating area 132 are connected by using a bonding structure, and the first heat dissipating area 131 and the second heat dissipating area 132 are separated by using a thermal insulation material. The second heat dissipating area 132 and the third heat dissipating area 133 are also connected by using a bonding structure, and the second heat dissipating area 132 and the third heat dissipating area 133 are also separated by using a thermal insulation material.

Optionally, as shown in FIG. 12, bonding structures between different sub-rings of the heat dissipating ring 120 fit bonding structures between different areas of the heat dissipating lid 130. Specifically, the bonding structure between the first sub-ring 121 and the second sub-rings 122 and 124 fits the bonding structure between the first heat dissipating area 131 and the second heat dissipating area 132, and the bonding structure between the third sub-ring 123 and the second sub-rings 122 and 124 fits the bonding structure between the second heat dissipating area 132 and the third heat dissipating area 133.

Optionally, the heat dissipating ring 120 may be divided into multiple sub-rings according to area division of the heat dissipating lid 130 or according to chip distribution inside the heat dissipating ring 120.

Optionally, the heat dissipating ring 120 may be of the rectangular closed structure shown in FIG. 3 or may be of the rectangular separated structure shown in FIG. 12. The heat dissipating ring 120 in this embodiment of this application may alternatively be of another structure. This is not limited in this embodiment of this application.

Optionally, in this embodiment of this application, the heat dissipating ring 120 and the heat dissipating lid 130 may be connected by using a thermal insulation material or may be connected directly.

Specifically, as shown in FIG. 1, the heat dissipating ring 120 and the heat dissipating lid 130 are separated by using a thermal insulation material. The thermal insulation material may be thermal insulation adhesive or may be another material of a low heat conductivity, for example, the thermal insulation material 160. This is not limited in this embodiment of this application.

As shown in FIG. 13, the heat dissipating ring 120 and the heat dissipating lid 130 are connected. In this case, the heat dissipating ring 120 and the heat dissipating lid 130 form a whole. For example, as shown in FIG. 13, the heat dissipating ring 120 and the heat dissipating lid 130 are connected to form the heat dissipating lid 130.

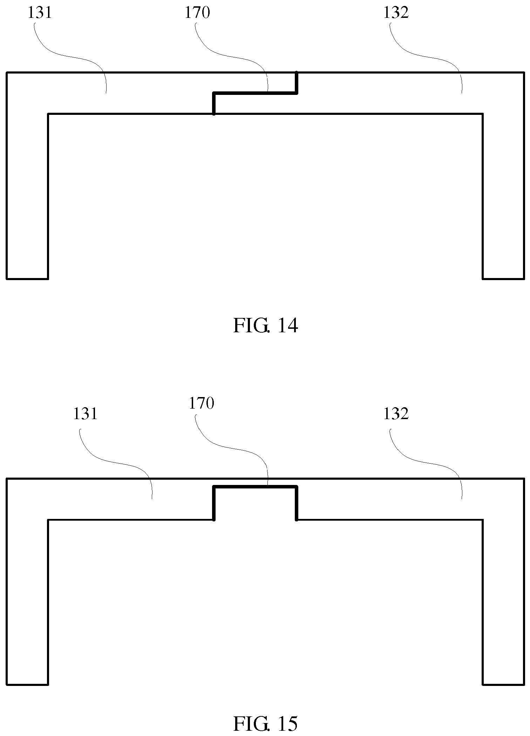

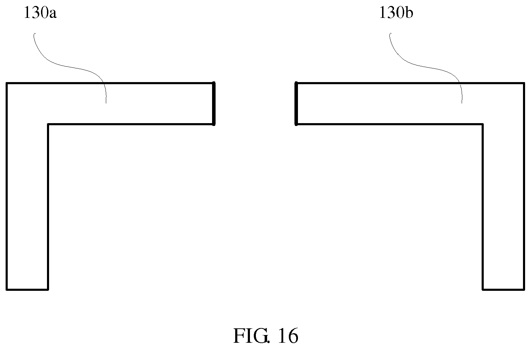

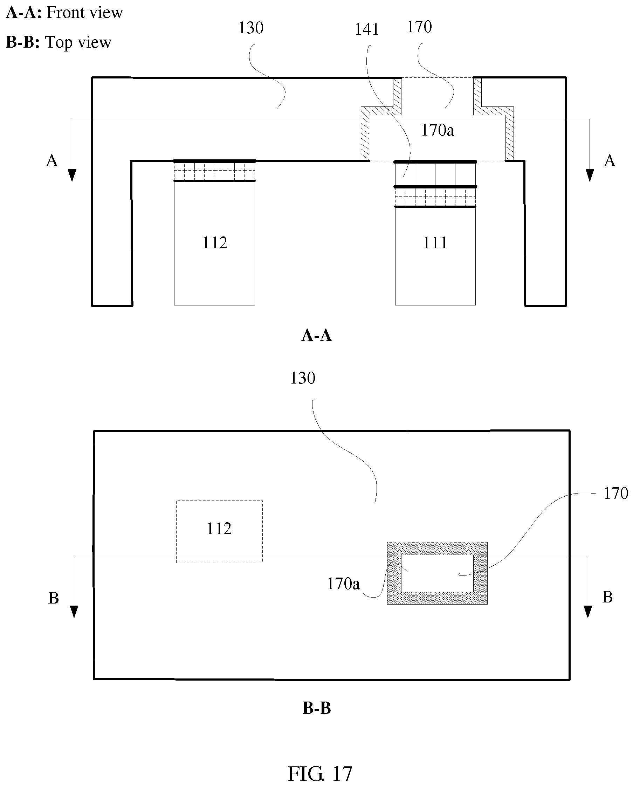

Optionally, when the heat dissipating ring 120 and the heat dissipating lid 130 are a whole, the heat dissipating lid 130 may be a whole shown in FIG. 13; may be a heat dissipating lid 130 shown in FIG. 14, where the heat dissipating lid 130 is divided into different areas and the different areas are connected by using a bonding structure; may be a heat dissipating lid 130 shown in FIG. 15, where the heat dissipating lid 130 is divided into different areas and the different areas are connected by using a slotted structure; may be a heat dissipating lid 130 shown in FIG. 16, where the heat dissipating lid 130 is divided into different areas and the different areas are separated by air; or may be a heat dissipating lid 130 shown in FIG. 17 (A-A and B-B), where the heat dissipating lid 130 includes an opening structure 170 and the opening structure 170 is connected to the heat dissipating lid 130 by using a bonding structure.

Optionally, in this embodiment of this application, when the at least one thermoelectric refrigeration chip 140 includes only one thermoelectric refrigeration chip 141, the thermoelectric refrigeration chip 141 may be disposed above the heat dissipating lid 130, may be disposed inside the heat dissipating lid 130, or may be disposed under the heat dissipating lid 130.

Specifically, as shown in FIG. 1, the at least one thermoelectric refrigeration chip 140 includes the thermoelectric refrigeration chip 141, the thermoelectric refrigeration chip 141 is disposed above the heat dissipating lid 130, and the cold end of the thermoelectric refrigeration chip 141 is attached to an upper surface of the heat dissipating lid 130.

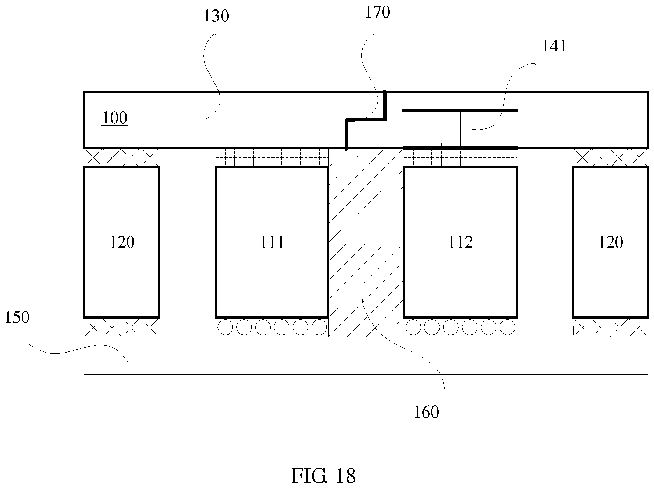

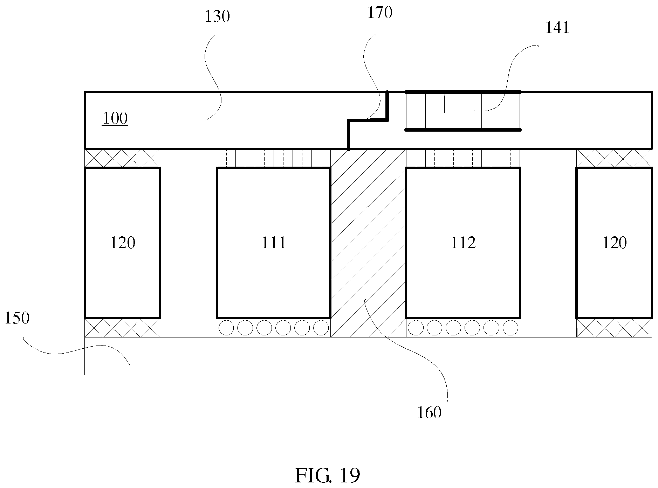

As shown in FIG. 18, the at least one thermoelectric refrigeration chip 140 includes the thermoelectric refrigeration chip 141, the thermoelectric refrigeration chip 141 is disposed inside the heat dissipating lid 130, and the cold end of the thermoelectric refrigeration chip 141 is attached to a lower surface of the heat dissipating lid 130. As shown in FIG. 19, the at least one thermoelectric refrigeration chip 140 includes the thermoelectric refrigeration chip 141, the thermoelectric refrigeration chip 141 is disposed inside the heat dissipating lid 130, and the hot end of the thermoelectric refrigeration chip 141 is attached to the upper surface of the heat dissipating lid 130. Optionally, when a thickness of the thermoelectric refrigeration chip 141 is the same as that of the heat dissipating lid 130, the cold end of the thermoelectric refrigeration chip 141 is attached to the lower surface of the heat dissipating lid 130 and the hot end of thermoelectric refrigeration chip 141 is attached to the upper surface of the heat dissipating lid 130.

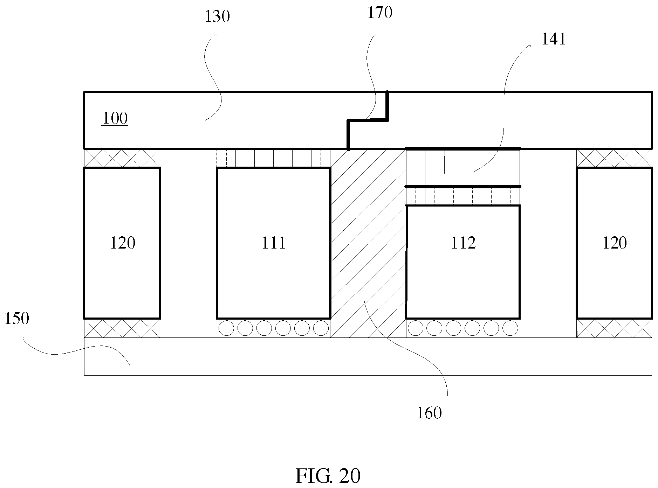

As shown in FIG. 20, the at least one thermoelectric refrigeration chip 140 includes the thermoelectric refrigeration chip 141 and the thermoelectric refrigeration chip 141 is disposed under the heat dissipating lid 130. The cold end of the thermoelectric refrigeration chip 141 is attached to the chip 112, the hot end of thermoelectric refrigeration chip 141 is attached to the lower surface of the heat dissipating lid 130, and the thermoelectric refrigeration chip 141 is secured to the chip 112 by using thermally conductive adhesive.

Optionally, in this embodiment of this application, the at least one thermoelectric refrigeration chip 140 includes multiple thermoelectric refrigeration chips. For example, the at least one thermoelectric refrigeration chip 140 includes the thermoelectric refrigeration chip 141 and a thermoelectric refrigeration chip 142. The thermoelectric refrigeration chip 141 may be disposed above the heat dissipating lid 130, may be disposed inside the heat dissipating lid 130, or may be disposed under the heat dissipating lid 130. The thermoelectric refrigeration chip 142 may be disposed above the heat dissipating lid 130, may be disposed inside the heat dissipating lid 130, or may be disposed under the heat dissipating lid 130.

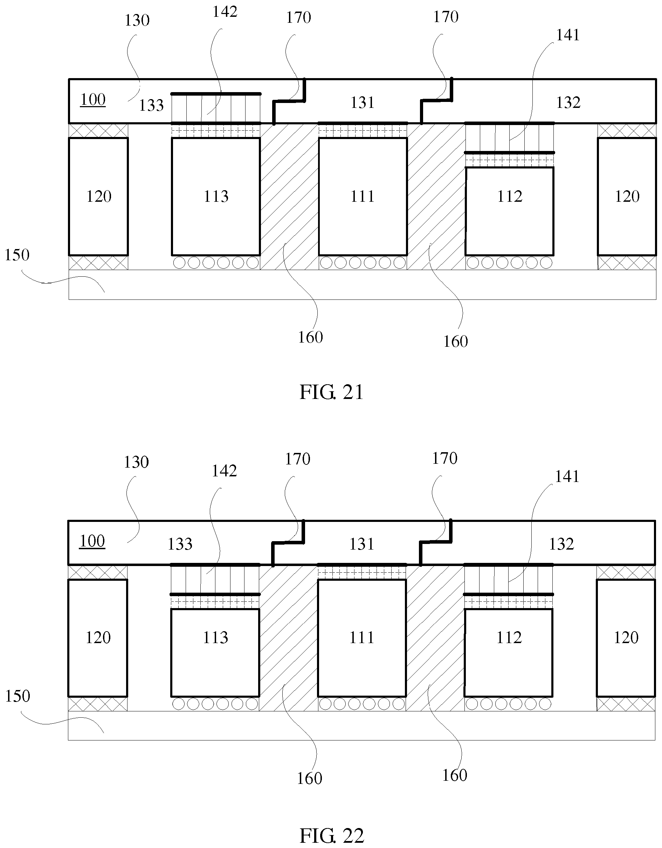

Specifically, as shown in FIG. 21, the at least one thermoelectric refrigeration chip 140 includes the thermoelectric refrigeration chip 141 and the thermoelectric refrigeration chip 142. The thermoelectric refrigeration chip 141 is disposed under the heat dissipating lid 130, the cold end of the thermoelectric refrigeration chip 141 is attached to the chip 112, the hot end of the thermoelectric refrigeration chip 141 is attached to the lower surface of the heat dissipating lid 130, and the thermoelectric refrigeration chip 141 is secured to the chip 112 by using thermally conductive adhesive. The thermoelectric refrigeration chip 142 is disposed inside the heat dissipating lid 130, and a cold end of the thermoelectric refrigeration chip 142 is attached to the lower surface of the heat dissipating lid 130. In this case, the heat dissipating lid is divided into the following three areas by using two bonding structures: the first heat dissipating area 131, the second heat dissipating area 132, and the third heat dissipating area 133. One end of the chip 111 is secured under the first heat dissipating area 131 by using thermally conductive adhesive, one end of the chip 112 is secured under the second heat dissipating area 132 by using the thermally conductive adhesive and the thermoelectric refrigeration chip 141, and one end of the chip 113 is secured under the third heat dissipating area 133 by using the thermally conductive adhesive. The chip 111 and the chip 112 are separated by using the thermal insulation material 160, and the chip 111 and the chip 113 are also separated by using the thermal insulation material 160.

As shown in FIG. 22, the at least one thermoelectric refrigeration chip 140 includes the thermoelectric refrigeration chip 141 and the thermoelectric refrigeration chip 142. The thermoelectric refrigeration chip 141 is disposed under the heat dissipating lid 130, the cold end of the thermoelectric refrigeration chip 141 is attached to the chip 112, the hot end of the thermoelectric refrigeration chip 141 is attached to the lower surface of the heat dissipating lid 130, and the thermoelectric refrigeration chip 141 is secured to the chip 112 by using the thermally conductive adhesive. The thermoelectric refrigeration chip 142 is disposed under the heat dissipating lid 130, the cold end of the thermoelectric refrigeration chip 142 is attached to the chip 113, a hot end of the thermoelectric refrigeration chip 142 is attached to the lower surface of the heat dissipating lid 130, and the thermoelectric refrigeration chip 142 is secured to the chip 113 by using thermally conductive adhesive. In this case, the heat dissipating lid is divided into the following three areas by using two bonding structures: the first heat dissipating area 131, the second heat dissipating area 132, and the third heat dissipating area 133. One end of the chip 111 is secured under the first heat dissipating area 131 by using the thermally conductive adhesive, one end of the chip 112 is secured under the second heat dissipating area 132 by using the thermally conductive adhesive and the thermoelectric refrigeration chip 141, and one end of the chip 113 is secured under the third heat dissipating area 133 by using the thermally conductive adhesive and the thermoelectric refrigeration chip 142. The chip 111 and the chip 112 are separated by using the thermal insulation material 160, and the chip 111 and the chip 113 are also separated by using the thermal insulation material 160.

Optionally, this embodiment of this application includes but is not limited to the foregoing disposing manners of different thermoelectric refrigeration chips.

Optionally, for the at least one thermoelectric refrigeration chip 140, a quantity of thermoelectric refrigeration chips may be determined according to a feature of each of the multiple chips. A thermoelectric refrigeration chip is disposed above a chip that requires intensified cooling.

Optionally, in this embodiment of this application, the chip packaging system 100 further includes a heat sink 180.

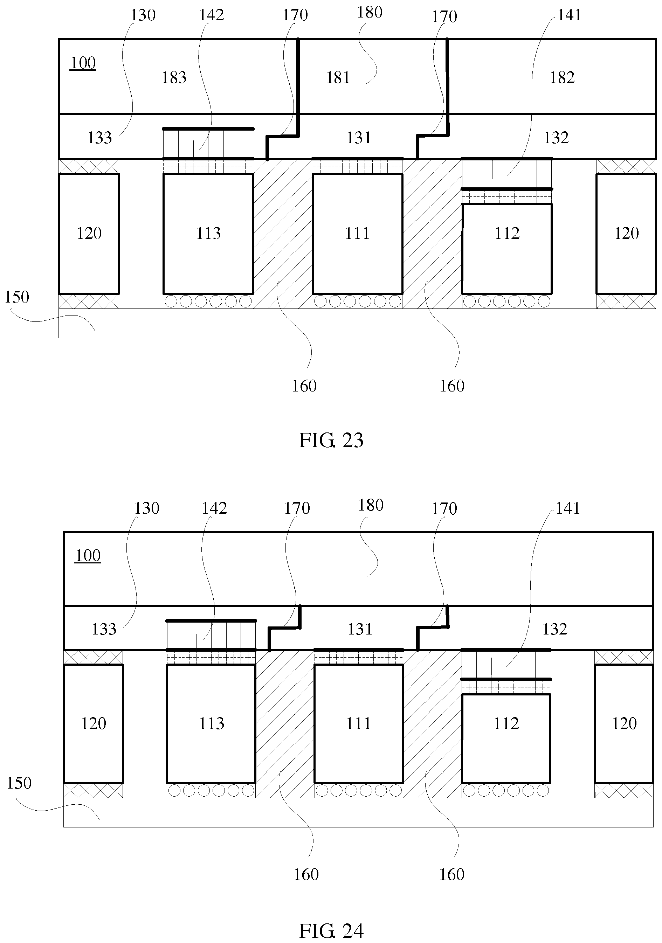

Specifically, as shown in FIG. 23, the chip packaging system 100 further includes the heat sink 180. The heat sink is disposed above the heat dissipating lid 130. The heat sink 180 includes three areas, which are a first heat sink area 181, a second heat sink area 182, and a third heat sink area 183, respectively. The first heat sink area 181 is attached to the first heat dissipating area 131 of the heat dissipating lid, the second heat sink area 182 is attached to the second heat dissipating area 132 of the heat dissipating lid, and the third heat sink area 183 is attached to the third heat dissipating area 133 of the heat dissipating lid. The first heat sink area 181 and the second heat sink area 182 are separated by using the thermal insulation material 160, and the first heat sink area 181 and the third heat sink area 183 are also separated by using the thermal insulation material 160.

As shown in FIG. 24, the chip packaging system 100 further includes a heat sink 180. The heat sink is disposed above the heat dissipating lid 130. The heat sink 180 is a whole and is attached to the first heat dissipating area 131, the second heat dissipating area 132, and the third heat dissipating area 133 of the heat dissipating lid.

Optionally, area division of the heat sink 180 may be determined according to a quantity of chips.

Optionally, the heat sink 180 is a micro cooling fin, and is configured to reduce heat of the heat dissipating lid 130.

Therefore, in the chip packaging system according to this embodiment of this application, heat generated by different chips of the multiple chips is conducted to an outer surface of a packaging structure through different heat conducting channels to reduce heat transfer between the different chips, and a thermoelectric refrigeration chip is used to improve a heat dissipation capability of a particular chip. This improves a heat dissipation capability of the packaging structure of a system-level package with multiple chips, implementing effective control on a temperature of the particular chip.

It should be understood that in embodiments of this application, the foregoing solution may be applied, but not limited to, design of various high-power chip packages, for example, a high-power chip used for a network. The chips in the foregoing solution include but are not limited to a wire bonding chip and a flip chip. Package forms used in the foregoing solution include but are not limited to various package forms such as 2.5-dimensional CoWoS (chip on wafer on substrate).

It should be further understood that sequence numbers of the foregoing processes do not mean execution sequences in various embodiments of this application. The execution sequences of the processes should be determined according to functions and internal logic of the processes, and should not be construed as any limitation on the implementation processes of the embodiments of this application.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

Therefore, the protection scope of this application shall be subject to the protection scope of the claims.

## Claims

1. A chip packaging system, comprising multiple chips (111, 112, 113), a substrate (150), a heat dissipating component, and at least one thermoelectric refrigeration chip (141), wherein
a heat dissipating ring (120) and a heat dissipating lid (130) are provided on the heat dissipating component, one end of the heat dissipating ring (120) is secured to the substrate (150), and the other end, opposite to the end secured to the substrate, of the heat dissipating ring (120) is secured to the heat dissipating lid (130) to support the heat dissipating lid (130); and the multiple chips (111, 112, 113) are disposed in space enclosed by the substrate (150), the heat dissipating ring (120), and the heat dissipating lid (130), and all of the multiple chips (111, 112, 113) are separated each other by using a thermal insulation material (160) or by air, wherein the heat dissipating ring (120) is of a separated structure and comprises multiple sub-rings, and the multiple sub-rings (121, 122, 123, 124) are connected by using a thermal insulation material to form the heat dissipating ring (120); and
each of the at least one thermoelectric refrigeration chip (141) is disposed above one of the multiple chips (111, 112, 113), one surface of each thermoelectric refrigeration chip (141) is a hot end (141a) and the other surface thereof is a cold end (141b), wherein the cold end (141b) of each thermoelectric refrigeration chip is disposed on a side close to the multiple chips (111, 112, 113) and is configured to absorb heat of the chips, and the hot end (141a) of each thermoelectric refrigeration chip is configured to conduct, by using the hot end, the heat absorbed by the cold end.

2. The system according to claim 1, wherein the multiple chips comprise a first chip (111) and a second chip (112), one end of the first chip is secured to the substrate (150) and the other end, opposite to the end secured to the substrate, of the first chip is secured to a first heat dissipating area (131) of the heat dissipating lid, and one end of the second chip is secured to the substrate and the other end, opposite to the end secured to the substrate, of the second chip is secured to a second heat dissipating area (132) of the heat dissipating lid.

3. The system according to claim 2, wherein
the first heat dissipating area and the second heat dissipating area are connected by using a bonding structure (170), and the first heat dissipating area and the second heat dissipating area are separated by using the thermal insulation material; or
the first heat dissipating area and the second heat dissipating area are connected by using a slotted structure (170), and the first heat dissipating area and the second heat dissipating area are separated by using a slot; or
the first heat dissipating area and the second heat dissipating area are separated by air.

4. The system according to any one of claims 1 to 3, wherein the heat dissipating ring and the heat dissipating lid are connected by using a thermal insulation material.

5. The system according to any one of claims 1 to 3, wherein the heat dissipating ring and the heat dissipating lid are connected directly.

6. The system according to any one of claims 1 to 5, wherein the at least one thermoelectric refrigeration chip comprises a first thermoelectric refrigeration chip, the first thermoelectric refrigeration chip is disposed above the heat dissipating lid, and a cold end of the first thermoelectric refrigeration chip is attached to an upper surface of the heat dissipating lid.

7. The system according to any one of claims 1 to 6, wherein the at least one thermoelectric refrigeration chip comprises a second thermoelectric refrigeration chip, the second thermoelectric refrigeration chip is disposed inside the heat dissipating lid, and a cold end of the second thermoelectric refrigeration chip is attached to a lower surface of the heat dissipating lid or a hot end of the second thermoelectric refrigeration chip is attached to the upper surface of the heat dissipating lid.

8. The system according to any one of claims 1 to 7, wherein the at least one thermoelectric refrigeration chip comprises a third thermoelectric refrigeration chip, the third thermoelectric refrigeration chip is disposed under the heat dissipating lid, and a cold end of the third thermoelectric refrigeration chip is attached to an upper surface of one of the multiple chips.

9. The system according to any one of claims 1 to 5, wherein the at least one thermoelectric refrigeration chip comprises a fourth thermoelectric refrigeration chip, wherein
the fourth thermoelectric refrigeration chip is disposed above the heat dissipating lid, and a cold end of the fourth thermoelectric refrigeration chip is attached to an upper surface of the heat dissipating lid; or
the fourth thermoelectric refrigeration chip is disposed inside the heat dissipating lid, and a cold end of the fourth thermoelectric refrigeration chip is attached to a lower surface of the heat dissipating lid or a hot end of the fourth thermoelectric refrigeration chip is attached to an upper surface of the heat dissipating lid; or
the fourth thermoelectric refrigeration chip is disposed under the heat dissipating lid, and a cold end of the fourth thermoelectric refrigeration chip is attached to an upper surface of one of the multiple chips.

10. The system according to any one of claims 1 to 9, wherein the system further comprises a heat sink (180), and the heat sink is disposed above the heat dissipating lid and is configured to absorb heat of the heat dissipating lid.

11. The system according to claim 10, wherein the heat sink (180) comprises multiple areas, the multiple areas comprise a first heat sink area (181) and a second heat sink area (182), the first heat sink area is attached to the first heat dissipating area of the heat dissipating lid, the second heat sink area is attached to the second heat dissipating area of the heat dissipating lid, and the first heat sink area and the second heat sink area are connected by using the thermal insulation material.

12. The system according to claim 10, wherein the heat sink is a whole.

13. The system according to any one of claims 1 to 12, wherein a heat conductivity of the thermal insulation material is less than 1.0 W/mK.

14. The system according to any one of claims 1 to 13, wherein the at least one thermoelectric refrigeration chip is a power-adjustable thermoelectric refrigeration chip.

## Patentansprüche

1. Chipaufbau- und -verbindungssystem, das mehrere Chips (111, 112, 113), ein Substrat (150), eine Wärmeableitungskomponente und wenigstens einen thermoelektrischen Kühlchip (141) umfasst, wobei
ein Wärmeableitungsring (120) und ein Wärmeableitungsdeckel (130) an der Wärmeableitungskomponente bereitgestellt sind, ein Ende des Wärmeableitungsrings (120) an dem Substrat (150) befestigt ist und das andere Ende des Wärmeableitungsrings (120) gegenüber dem Ende, das an dem Substrat befestigt ist, an dem Wärmeableitungsdeckel (130) befestigt ist, um den Wärmeableitungsdeckel (130) zu stützen; und die mehreren Chips (111, 112, 113) in einem Raum angeordnet sind, der durch das Substrat (150), den Wärmeableitungsring (120) und den Wärmeableitungsdeckel (130) eingeschlossen ist, und alle mehreren Chips (111, 112, 113) durch Verwenden eines Wärmeisolierungsmaterials (160) oder durch Luft voneinander getrennt sind, wobei der Wärmeableitungsring (120) eine getrennte Struktur besitzt und mehrere Teilringe umfasst und die mehreren Teilringe (121, 122, 123, 124) durch Verwenden eines Wärmeisolierungsmaterials verbunden sind, um den Wärmeableitungsring (120) auszubilden; und
jeder des wenigstens einen thermoelektrischen Kühlchips (141) über einem der mehreren Chips (111, 112, 113) angeordnet ist, wobei eine Oberfläche jedes thermoelektrischen Kühlchips (141) ein heißes Ende (141a) und die andere Oberfläche davon ein kaltes Ende (141b) ist, wobei das kalte Ende (141b) jedes thermoelektrischen Kühlchips auf einer Seite nahe den mehreren Chips (111, 112, 113) angeordnet ist und konfiguriert ist, um Wärme der Chips aufzunehmen, und das heiße Ende (141a) jedes thermoelektrischen Kühlchips konfiguriert ist, um durch Verwenden des heißen Endes die Wärme zu leiten, die durch das kalte Ende aufgenommen wird.

2. System nach Anspruch 1, wobei die mehreren Chips einen ersten Chip (111) und einen zweiten Chip (112) umfassen, ein Ende des ersten Chips an dem Substrat (150) befestigt ist und das andere Ende des ersten Chips gegenüber dem Ende, das an dem Substrat befestigt ist, an einem ersten Wärmeableitungsbereich (131) des Wärmeableitungsdeckels befestigt ist, und ein Ende des zweiten Chips an dem Substrat und das andere Ende des zweiten Chips gegenüber dem Ende, das an dem Substrat befestigt ist, an einem zweiten Wärmeableitungsbereich (132) des Wärmeableitungsdeckels befestigt ist.

3. System nach Anspruch 2, wobei
der erste Wärmeableitungsbereich und der zweite Wärmeableitungsbereich durch Verwenden einer Bondstruktur (170) verbunden sind und der erste Wärmeableitungsbereich und der zweite Wärmeableitungsbereich durch Verwenden des Wärmeisolierungsmaterials getrennt sind; oder
der erste Wärmeableitungsbereich und der zweite Wärmeableitungsbereich durch Verwenden einer Schlitzstruktur (170) verbunden sind und der erste Wärmeableitungsbereich und der zweite Wärmeableitungsbereich durch Verwenden eines Schlitzes getrennt sind; oder
der erste Wärmeableitungsbereich und der zweite Wärmeableitungsbereich durch Luft getrennt sind.

4. System nach einem der Ansprüche 1 bis 3, wobei der Wärmeableitungsring und der Wärmeableitungsdeckel durch Verwenden eines Wärmeisolierungsmaterials verbunden sind.

5. System nach einem der Ansprüche 1 bis 3, wobei der Wärmeableitungsring und der Wärmeableitungsdeckel direkt verbunden sind.

6. System nach einem der Ansprüche 1 bis 5, wobei der wenigstens eine thermoelektrische Kühlchip einen ersten thermoelektrischen Kühlchip umfasst, der erste thermoelektrische Kühlchip über dem Wärmeableitungsdeckel angeordnet ist und ein kaltes Ende des ersten thermoelektrischen Kühlchips an einer oberen Oberfläche des Wärmeableitungsdeckels angebracht ist.

7. System nach einem der Ansprüche 1 bis 6, wobei der wenigstens eine thermoelektrische Kühlchip einen zweiten thermoelektrischen Kühlchip umfasst, der zweite thermoelektrische Kühlchip innerhalb des Wärmeableitungsdeckels angeordnet ist und ein kaltes Ende des zweiten thermoelektrischen Kühlchips an einer unteren Oberfläche des Wärmeableitungsdeckels angebracht ist oder ein heißes Ende des zweiten thermoelektrischen Kühlchips an der oberen Oberfläche des Wärmeableitungsdeckels angebracht ist.

8. System nach einem der Ansprüche 1 bis 7, wobei der wenigstens eine thermoelektrische Kühlchip einen dritten thermoelektrischen Kühlchip umfasst, der dritte thermoelektrische Kühlchip unter dem Wärmeableitungsdeckel angeordnet ist und ein kaltes Ende des dritten thermoelektrischen Kühlchips an einer oberen Oberfläche eines der mehreren Chips angebracht ist.

9. System nach einem der Ansprüche 1 bis 5, wobei der wenigstens eine thermoelektrische Kühlchip einen vierten thermoelektrischen Kühlchip umfasst, wobei
der vierte thermoelektrische Kühlchip über dem Wärmeableitungsdeckel angeordnet ist und ein kaltes Ende des vierten thermoelektrischen Kühlchips an einer oberen Oberfläche des Wärmeableitungsdeckels angebracht ist; oder
der vierte thermoelektrische Kühlchip innerhalb des Wärmeableitungsdeckels angeordnet ist und ein kaltes Ende des vierten thermoelektrischen Kühlchips an einer unteren Oberfläche des Wärmeableitungsdeckels angebracht ist oder ein heißes Ende des vierten thermoelektrischen Kühlchips an einer oberen Oberfläche des Wärmeableitungsdeckels angebracht ist; oder
der vierte thermoelektrische Kühlchip unter dem Wärmeableitungsdeckel angeordnet ist und ein kaltes Ende des vierten thermoelektrischen Kühlchips an einer oberen Oberfläche eines der mehreren Chips angebracht ist.

10. System nach einem der Ansprüche 1 bis 9, wobei das System ferner eine Wärmesenke (180) umfasst und die Wärmesenke über dem Wärmeableitungsdeckel angeordnet ist und konfiguriert ist, um Wärme des Wärmeableitungsdeckels aufzunehmen.

11. System nach Anspruch 10, wobei die Wärmesenke (180) mehrere Bereiche umfasst, die mehreren Bereiche einen ersten Wärmesenkenbereich (181) und einen zweiten Wärmesenkenbereich (182) umfassen, der erste Wärmesenkenbereich an dem ersten Wärmeableitungsbereich des Wärmeableitungsdeckels angebracht ist, der zweite Wärmesenkenbereich an dem zweiten Wärmeableitungsbereich des Wärmeableitungsdeckels angebracht ist, und der erste Wärmesenkenbereich und der zweite Wärmesenkenbereich durch Verwenden des Wärmeisolierungsmaterials verbunden sind.

12. System nach Anspruch 10, wobei die Wärmesenke ein Ganzes ist.

13. System nach einem der Ansprüche 1 bis 12, wobei eine Wärmeleitfähigkeit des Wärmeisolierungsmaterials weniger als 1,0 W/mK beträgt.

14. System nach einem der Ansprüche 1 bis 13, wobei der wenigstens eine thermoelektrische Kühlchip ein elektrisch einstellbarer thermoelektrischer Kühlchip ist.

## Revendications

1. Système d'encapsulation de puces, comprenant de multiples puces (111, 112, 113), un substrat (150), un composant de dissipation thermique et au moins une puce de refroidissement thermoélectrique (141),
un anneau de dissipation thermique (120) et un couvercle de dissipation thermique (130) étant disposés sur le composant de dissipation thermique, une extrémité de l'anneau de dissipation thermique (120) étant fixée au substrat (150), et l'autre extrémité, opposée à l'extrémité fixée au substrat, de l'anneau de dissipation thermique (120) étant fixée au couvercle de dissipation thermique (130) pour supporter le couvercle de dissipation thermique (130) ; et les multiples puces (111, 112, 113) étant disposées dans un espace fermé par le substrat (150), l'anneau de dissipation thermique (120) et le couvercle de dissipation thermique (130), et toutes les multiples puces (111, 112, 113) étant séparées les unes des autres à l'aide d'un matériau d'isolation thermique (160) ou par de l'air, l'anneau de dissipation thermique (120) étant d'une structure séparée et comprenant de multiples sous-anneaux, et les multiples sous-anneaux (121, 122, 123, 124) étant connectés à l'aide d'un matériau d'isolation thermique pour former l'anneau de dissipation thermique (120) ; et
chacune de l'au moins une puce de refroidissement thermoélectrique (141) étant disposée au-dessus de l'une des multiples puces (111, 112, 113), une surface de chaque puce de refroidissement thermoélectrique (141) étant une extrémité chaude (141a) et l'autre surface de celle-ci étant une extrémité froide (141b), l'extrémité froide (141b) de chaque puce de refroidissement thermoélectrique étant disposée sur un côté proche des multiples puces (111, 112, 113) et étant configurée pour absorber la chaleur des puces, et l'extrémité chaude (141a) de chaque puce de refroidissement thermoélectrique étant configurée pour conduire, à l'aide de l'extrémité chaude, la chaleur absorbée par l'extrémité froide.

2. Système selon la revendication 1, les multiples puces comprenant une première puce (111) et une seconde puce (112), une extrémité de la première puce étant fixée au substrat (150) et l'autre extrémité, opposée à l'extrémité fixée au substrat, de la première puce, étant fixée à une première zone de dissipation thermique (131) du couvercle de dissipation thermique, et une extrémité de la seconde puce étant fixée au substrat et l'autre extrémité, opposée à l'extrémité fixée au substrat, de la seconde puce, étant fixée à une seconde zone de dissipation thermique (132) du couvercle de dissipation thermique.

3. Système selon la revendication 2,
la première zone de dissipation thermique et la seconde zone de dissipation thermique étant connectées à l'aide d'une structure de connexion (170), et la première zone de dissipation thermique et la seconde zone de dissipation thermique étant séparées à l'aide du matériau d'isolation thermique ; ou
la première zone de dissipation thermique et la seconde zone de dissipation thermique étant connectées à l'aide d'une structure à fentes (170), et la première zone de dissipation thermique et la seconde zone de dissipation thermique étant séparées à l'aide d'une fente ; ou
la première zone de dissipation thermique et la seconde zone de dissipation thermique étant séparées par de l'air.

4. Système selon l'une quelconque des revendications 1 à 3, l'anneau de dissipation thermique et le couvercle de dissipation thermique étant connectés à l'aide d'un matériau d'isolation thermique.

5. Système selon l'une quelconque des revendications 1 à 3, l'anneau de dissipation thermique et le couvercle de dissipation thermique étant connectés directement.

6. Système selon l'une quelconque des revendications 1 à 5, l'au moins une puce de refroidissement thermoélectrique comprenant une première puce de refroidissement thermoélectrique, la première puce de refroidissement thermoélectrique étant disposée au-dessus du couvercle de dissipation thermique et une extrémité froide de la première puce de refroidissement thermoélectrique étant fixée à une surface supérieure du couvercle de dissipation thermique.

7. Système selon l'une quelconque des revendications 1 à 6, l'au moins une puce de refroidissement thermoélectrique comprenant une deuxième puce de refroidissement thermoélectrique, la deuxième puce de refroidissement thermoélectrique étant disposée à l'intérieur du couvercle de dissipation thermique et une extrémité froide de la deuxième puce de refroidissement thermoélectrique étant fixée à une surface inférieure du couvercle de dissipation thermique ou une extrémité chaude de la deuxième puce de refroidissement thermoélectrique étant fixée à la surface supérieure du couvercle de dissipation thermique.

8. Système selon l'une quelconque des revendications 1 à 7, l'au moins une puce de refroidissement thermoélectrique comprenant une troisième puce de refroidissement thermoélectrique, la troisième puce de refroidissement thermoélectrique étant disposée sous le couvercle de dissipation thermique et une extrémité froide de la troisième puce de refroidissement thermoélectrique étant fixée à une surface supérieure de l'une des multiples puces.

9. Système selon l'une quelconque des revendications 1 à 5, l'au moins une puce de refroidissement thermoélectrique comprenant une quatrième puce de refroidissement thermoélectrique,
la quatrième puce de refroidissement thermoélectrique étant disposée au-dessus du couvercle de dissipation thermique, et une extrémité froide de la quatrième puce de refroidissement thermoélectrique étant fixée à une surface supérieure du couvercle de dissipation thermique ; ou
la quatrième puce de refroidissement thermoélectrique étant disposée à l'intérieur du couvercle de dissipation thermique, et une extrémité froide de la quatrième puce de refroidissement thermoélectrique étant fixée à une surface inférieure du couvercle de dissipation thermique ou une extrémité chaude de la quatrième puce de refroidissement thermoélectrique étant fixée à une surface supérieure du couvercle de dissipation thermique ; ou
la quatrième puce de refroidissement thermoélectrique étant disposée sous le couvercle de dissipation thermique, et une extrémité froide de la quatrième puce de refroidissement thermoélectrique étant fixée à une surface supérieure de l'une des multiples puces.

10. Système selon l'une quelconque des revendications 1 à 9, le système comprenant en outre un dissipateur thermique (180), et le dissipateur thermique étant disposé au-dessus du couvercle de dissipation thermique et étant configuré pour absorber la chaleur du couvercle de dissipation thermique.

11. Système selon la revendication 10, le dissipateur thermique (180) comprenant plusieurs zones, les multiples zones comprenant une première zone de dissipation thermique (181) et une seconde zone de dissipation thermique (182), la première zone de dissipation thermique étant fixée à la première zone de dissipation thermique du couvercle de dissipation thermique, la seconde zone de dissipation thermique étant fixée à la seconde zone de dissipation thermique du couvercle de dissipation thermique, et la première zone de dissipation thermique et la seconde zone de dissipation thermique étant connectées à l'aide du matériau d'isolation thermique.

12. Système selon la revendication 10, le dissipateur thermique étant un tout.

13. Système selon l'une quelconque des revendications 1 à 12, une conductivité thermique du matériau d'isolation thermique étant inférieure à 1,0 W/mK.

14. Système selon l'une quelconque des revendications 1 à 13, l'au moins une puce de refroidissement thermoélectrique étant une puce de refroidissement thermoélectrique à puissance réglable.
